# EUROPÄISCHE PATENTSCHRIFT

(11) **EP 2 781 928 B1**
(45) Veröffentlichungstag und Bekanntmachung des Hinweises auf die Patenterteilung: **13.01.2016**
(21) Anmeldenummer: 14000185.0
(22) Anmeldetag: 18.01.2014
(51) Int. Cl.: G01R 33/36, G01N 24/08, G01F 1/716

(54) **Signalanalysator, insbesondere für kernmagnetische Durchflussmessgeräte**
Signal analyser, in particular for nuclear magnetic flow meters
Analyseur de signaux, notamment pour appareils de mesure de débit à noyau magnétique

(30) Priorität: 19.03.2013 DE 102013004671; 12.04.2013 DE 102013006305
(43) Veröffentlichungstag der Anmeldung: 24.09.2014
(73) Patentinhaber: Krohne AG, 4019 Basel (CH)
(72) Erfinder: Duncker, Bart, NL 3755 HK Eemnes (NL); Hofstede, Jan Johannes Jacobus, NL -2803 SX Gouda (NL); Luik, Stephan Inge, NL - 2401 PG Alphen aan de Rijn (NL)
(74) Vertreter: Gesthuysen Patent- und Rechtsanwälte

(56) Entgegenhaltungen:
- DE-A1- 4 035 994
- DE-A1- 19 631 900
- US-A- 3 562 632

## Beschreibung

Die Erfindung betrifft einen Signalanalysator, insbesondere für kernmagnetische Durchflussmessgeräte, zur Anordnung in einem Leistungssignalpfad zwischen einem Signalgenerator zur Erzeugung eines elektrischen Anregungssignals und einer elektrischen Last, mit einer, bei Anordnung des Signalanalysators im Leistungssignalpfad, im Leistungssignalpfad liegenden Leistungssignalleitung zur Übertragung von elektrischen Signalen, mit einer Auskoppelschaltung zur Auskopplung eines das in die Last einfallende Anregungssignal charakterisierenden ersten Signals und zur Auskopplung eines den an der Last reflektierten Teil des Anregungssignals charakterisierenden zweiten Signals und mit einem Detektor zur Bestimmung des Verhältnisses der Größe des ersten Signals zur Größe des zweiten Signals und zur Bestimmung des Phasenunterschieds zwischen dem ersten Signal und dem zweiten Signal.

Die Atomkerne der Elemente, die einen Kernspin besitzen, besitzen auch ein durch den Kernspin hergerufenes magnetisches Moment. Der Kernspin kann als ein durch einen Vektor beschreibbarer Drehimpuls aufgefasst werden und entsprechend kann auch das magnetische Moment durch einen Vektor beschrieben werden, der parallel zum Vektor des Drehimpulses ausgerichtet ist. Der Vektor des magnetischen Moments eines Atomkerns richtet sich bei Anwesenheit eines makroskopischen Magnetfelds parallel zu dem Vektor des makroskopischen Magnetfelds an der Stelle des Atomkerns aus. Dabei präzessiert der Vektor des magnetischen Moments des Atomkerns um den Vektor des makroskopischen Magnetfelds an der Stelle des Atomkerns. Die Frequenz der Präzession wird als Larmorfrequenz ω_{L} bezeichnet und ist proportional zum Betrag der Magnetfeldstärke B. Die Larmorfrequenz berechnet sich gemäß der Formel ω_{L} = γ*B*, in welcher γ das gyromagnetische Verhältnis ist, das für Wasserstoffkerne maximal ist. Die Präzession des magnetischen Moments eines Atomkerns ist ein magnetisches Wechselfeld mit der Larmorfrequenz, welches ein elektrisches Wechselsignal mit der gleichen Frequenz in einer Spule induzieren kann. Messverfahren, welche die Präzession der magnetischen Momente von Atomkernen eines Mediums bei Anwesenheit eines makroskopischen Magnetfelds durch Anregung mittels eines gesteuerten Magnetfelds beeinflussen und die Wirkung der Anregung auswerten, werden als kernmagnetische Resonanz-Messverfahren bezeichnet. Ein Beispiel für Messgeräte, welche kernmagnetische Resonanz-Messverfahren umsetzen, sind kernmagnetische Durchflussmessgeräte. Diese können die Strömungsgeschwindigkeit eines Mediums in einem Messrohr messen, und sie können auch die Strömungsgeschwindigkeiten der einzelnen Phasen eines mehrphasigen Mediums und die relativen Anteile der einzelnen Phasen an dem mehrphasigen Medium messen, wenn die einzelnen Phasen zu unterscheidbaren kemmagnetischen Resonanzen anregbar sind. Kernmagnetische Durchflussmessgeräte können z. B. zur mitlaufenden Durchflussmessung des aus Ölquellen geförderten mehrphasigen Mediums eingesetzt werden. Dieses Medium besteht im Wesentlichen aus den flüssigen Phasen Rohöl und Salzwasser und der gasförmigen Phase Erdgas, wobei alle Phasen die zu kernmagnetischen Resonanzen anregbaren Wasserstoffkerne enthalten und die einzelnen Phasen zu unterschiedlichen kernmagnetischen Resonanzen anregbar sind.

Die Messung des aus Ölquellen geförderten mehrphasigen Mediums kann auch mit Testseparatoren erfolgen. In einen Testseparator wird das geförderte Medium über einen Zeitraum eingeleitet, worauf der Testseparator die einzelnen Phasen des Mediums voneinander trennt und die Anteile der einzelnen Phasen an dem Medium bestimmt. Jedoch sind Testseparatoren im Gegensatz zu kernmagnetisehen Durchflussmessgeräten nicht im Stande, Rohölanteile kleiner als 5 % zuverlässig zu messen, Da der Rohölanteil einer jeden Ölquelle stetig absinkt und der Rohölanteil einer Vielzahl von Ölquellen bereits geringer als 5 % ist, ist es derzeit nicht möglich, diese Ölquellen unter Verwendung von Testseparatoren wirtschaftlich auszubeuten. Um auch Ölquellen mit einem sehr geringen Rohölanteil weiterhin ausbeuten zu können, sind entsprechend genaue Durchflussmessgeräte für das aus mehreren Phasen bestehende Medium erforderlich, welche vorzugsweise die Ölförderung nicht unterbrechen. Hierfür sind insbesondere kernmagnetische Durchflussmessgeräte geeignet.

Bei kernmagnetischen Durchflussmessgeräten wird das Magnetfeld, welches die magnetischen Momente der Atomkerne des Mediums zunächst ausrichtet und die Larmorfrequenz der Präzession bestimmt, durch eine Magnetisierungsvorrichtung erzeugt. Das gesteuerte Magnetfeld, welches die ausgerichteten und präzessierenden Atomkerne anregt, kann durch eine elektrische Spule erzeugt werden. Die Spule ist eine Komponente der elektrischen Last des Signalanalysators und die elektrische Last ist durch die Leistungssignalleitung mit dem die elektrischen Anregungssignale erzeugenden Signalgenerator des kernmagnetischen Durchflussmessgeräts elektrisch verbunden. Zur Anregung besonders geeignet sind mit der Larmorfrequenz oszillierende Anregungssignale. Zur Ermöglichung der effizienten Übertragung der Leistung vom Signalgenerator über die Leistungssignalleitung zur Spule entlang dem Leistungssignalpfad ist die elektrische Last daher für gewöhnlich zu einem Schwingkreis mit einstellbarer Resonanzfrequenz und einstellbarer Eingangsimpedanz weitergebildet.

Zur Umsetzung der effizienten Übertragung der Leistung kann zum einen die Resonanzfrequenz der elektrischen Last auf die Larmorfrequenz der zu messenden Phase des Mediums abgestimmt werden. Zum anderen kann Leistungsanpassung im Leistungssignalpfad vorgenommen werden. Leistungsanpassung ist bei Abstimmung der Ausgangsimpedanz des Signalgenerators, der Leitungswellenimpedanz der Leistungssignalleitung und der Eingangsimpedanz der Last aufeinander gegeben. Ein Maß für Leistungsanpassung der elektrischen Last ist das Verhältnis zwischen der in die Last einfallenden Leistung des Anregungssignals und dem von der Last reflektierten Anteil der Leistung des einfallenden Anregungssignals. Bei Leistungsanpassung tritt keine Reflexion des in die Last einfallenden Anregungssignals an der Last auf.

Aus dem Stand der Technik bekannte Signalanalysatoren, insbesondere für kernmagnetische Durchflussmessgeräte, der eingangs beschriebenen Art sind zum Beispiel aus der DE 196 31 900 A1 bekannt. Sie weisen Auskoppelschaltungen mit einem ersten Richtkoppler und einem zweiten Richtkoppler auf. Der erste Richtkoppler erzeugt ein das in die Last einfallende Anregungssignal charakterisierende erstes Signal und der zweite Richtkoppler erzeugt ein den an der Last reflektierten Teil des Anregungssignals charakterisierende zweites Signal. Dabei ist die Phasenlage des ersten Signals in Bezug auf die Phasenlage der Spannung des Anregungssignals und die Phasenlage des zweiten Signals in Bezug auf die Phasenlage der Spannung des reflektierten Teils des Anregungssignals gleich, wobei die beiden Spannungen Maße für die über den Leistungssignalpfad übertragenen Leistungen sind. Wenn die Ausgangsimpedanz des Signalgenerators keine Reaktanz aufweist, was für gewöhnlich der Fall ist, dann beträgt bei dem aus dem Stand der Technik bekannten Signalanalysator und bei üblichen Leistungssignalleitungen der für Leistungsanpassung notwendige Phasenunterschied zwischen dem ersten Signal und dem zweiten Signal 0°. Phasenunterschiede im Bereich um 0° beeinträchtigen die Auswertung durch den Detektor jedoch.

Die Aufgabe der vorliegenden Erfindung ist daher die Angabe eines Signalanalysators, insbesondere für kernmagnetische Durchflussmessgeräte, mit verbesserten Eigenschaften und vorzugsweise einer verbesserten Auswertung des für Leistungsanpassung erforderlichen Phasenunterschieds zwischen dem ersten Signal und dem zweiten Signal.

Der erfindungsgemäße Signalanalysator, insbesondere für kernmagnetische Durchflussmessgeräte, bei dem die zuvor hergeleitete und aufgezeigte Aufgabe gelöst ist, ist zunächst und im Wesentlichen dadurch gekennzeichnet, dass die Auskoppelschaltung einen ersten Transformator und einen zweiten Transformator aufweist, dass der erste Transformator eine Primärseite mit einem Eingang und einem Ausgang und eine Sekundärseite mit einem Eingang und einem Ausgang aufweist und der zweite Transformator eine Primärseite mit einem Eingang und einem Ausgang und eine Sekundärseite mit einem Eingang und einem Ausgang aufweist, dass die Spannung am primärseitigen Eingang in Bezug auf den primärseitigen Ausgang jedes Transformators in Phase mit der Spannung an dessen sekundärseitigem Eingang in Bezug auf dessen sekundärseitigem Ausgang ist, dass der primärseitige Eingang des ersten Transformators mit der Leistungssignalleitung und der primärseitige Ausgang des ersten Transformators mit einem Bezugspotential verbunden ist, der primärseitige Eingang und der primärseitige Ausgang des zweiten Transformators mit der Leistungssignalleitung verbunden sind und der durch die Leistungssignalleitung fließende Strom durch die Primärseite des zweiten Transformators fließt, dass der sekundärseitige Eingang des zweiten Transformators mit dem Bezugspotential und der sekundärseitige Ausgang des zweiten Transformators mit dem sekundärseitigen Eingang des ersten Transformators verbunden ist und dass am sekundärseitigen Ausgang des ersten Transformators das erste Signal anliegt und an der Verbindung von dem sekundärseitigen Eingang des ersten Transformators und dem sekundärseitigen Ausgang des zweiten Transformators das zweite Signal anliegt.

Der erfindungsgemäße Signalanalysator hat gegenüber den aus dem Stand der Technik bekannten Signalanalysatoren zunächst den Vorteil, dass statt zwei Richtkopplern nur noch ein die zwei Transformatoren umfassender Richtkoppler in der Auskoppelschaltung vorhanden ist, was Herstellungsaufwand und Herstellungskosten reduziert. Ein weiterer Vorteil des erfindungsgemäßen Signalanalysators ist, dass der für Leistungsanpassung erforderliche Phasenunterschied zwischen dem ersten Signal und dem zweiten Signal größer ist als der bei den aus dem Stand der Technik bekannten Signalanalysatoren erforderliche Phasenunterschied. Dadurch ist eine verbesserte Auswertung des Phasenunterschieds durch den gleichen Detektor möglich. Wenn die Ausgangsimpedanz des Signalgenerators keine Reaktanz aufweist, dann ist bei dem erfindungsgemäßen Signalanalysator und bei üblichen Leistungssignalleitungen der für Leistungsanpassung notwendige Betrag des Phasenunterschieds zwischen dem ersten Signal und dem zweiten Signal 90°. Phasenunterschiede im Bereich um 90° beeinträchtigen die Auswertung durch den Detektor nicht.

Phasenunterschiede von zwei Signalen im Bereich um 90° sind von aus dem Stand der Technik bekannten Detektoren mit höherer Genauigkeit detektierbar als Phasenunterschiede im Bereich um 0°. Darüber hinaus können viele handelsübliche Detektoren, wie z. B. von Analog Devices das Modell AD8302, nur Phasenunterschiede zwischen zwei Signalen in einem Bereich von 0° bis 180° detektieren. Um diesen Detektor einsetzen zu können, ist daher bei aus dem Stand der Technik bekannten Signalanalysatoren oftmals ein zusätzlicher Phasenschieber, der die Phasenlage zwischen dem ersten und dem zweiten Signal verschiebt, erforderlich.

Obwohl hier von kernmagnetischen Durchflussmessgeräten die Rede ist, kann der erfindungsgemäße Signalanalysator dennoch überall dort eingesetzt werden, wo ein entsprechendes erstes Signal und zweites Signal zu analysieren sind. Auch kann das von dem erfindungsgemäßen Signalanalysator bestimmte Verhältnis der Größe des ersten Signals zur Größe des zweiten Signals und der bestimmte Phasenunterschiede zwischen dem ersten Signal und dem zweiten Signal nicht nur zur Leistungsanpassung, sondern zu beliebigen Anpassungen und Analysen verwendet werden.

Bei einer bevorzugten Ausgestaltung des erfindungsgemäßen Signalanalysators ist der zweite Transformator in Ausbreitungsrichtung des Anregungssignals im Leistungssignalpfad vor dem ersten Transformator angeordnet. Dadurch eilt das erste Signal dem zweiten Signal bei ohmscher Ausgangsimpedanz des Signalgenerators und ohmscher Eingangsimpedanz der Last um 90° voraus. Zur Vereinfachung der Auskoppelschaltung kann das Übersetzungsverhältnis des zweiten Transformators der Kehrwert des Übersetzungsverhältnisses des ersten Transformators sein. Demnach können zwei identische Transformatoren verwendet werden, wenn bei einem der beiden Transformatoren die Primärseite und die Sekundärseite miteinander vertauscht sind. Zwei identische Transformatoren reduzieren die Kosten des Signalanalysators weiter. Der sekundärseitige Ausgang des ersten Transformators kann über einen ersten Abschlusswiderstand mit dem Bezugspotential verbunden sein und die Verbindung von dem sekundärseitigen Ausgang des zweiten Transformators und dem sekundärseitigen Eingang des ersten Transformators kann über einen zweiten Abschlusswiderstand mit dem Bezugspotential verbunden sein. Als Wert für jeden der beiden Abschlusswiderstände bietet sich der Leitungswellenwiderstand der Leistungssignalleitung an. Durch diese Wahl der Werte der Abschlusswiderstände werden Reflexionen von sich im Leistungssignalpfad ausbreitenden Signalen vermieden.

Bei einer weiteren bevorzugten Ausgestaltung des erfindungsgemäßen Signalanalysators ist das erste Signal einem ersten Signalkonditionierer und das zweite Signal einem zweiten Signalkonditionierer zugeführt. Im Signalpfad des ersten Signalkonditionierers sind ein erstes Dämpfungsglied und ein erstes Tiefpassfilter angeordnet. Dementsprechend sind im Signalpfad des zweiten Signalkonditionierers ein zweites Dämpfungsglied und ein zweites Tiefpassfilter angeordnet. Die beiden Tiefpassfilter sind zur Dämpfung von unerwünschten Frequenzanteilen in den beiden Signalen ausgelegt. Vorzugsweise ist in dem Signalpfad jeder der beiden Signalkonditionierer das Tiefpassfilter in Ausbreitungsrichtung des Signals vor dem Dämpfungsglied angeordnet. Weiterhin ist es vorteilhaft, wenn die Dämpfung des ersten Dämpfungsglieds und die Dämpfung des zweiten Dämpfungsglieds derart aufeinander abgestimmt sind, dass das erste Signal am Ausgang des ersten Dämpfungsglieds und das zweite Signal am Ausgang des zweiten Dämpfungsglieds für die Weiterverarbeitung hinreichend gleiche Größen aufweisen. Insbesondere können bei der Einstellung der Dämpfungen die Übersetzungsverhältnisse der beiden Transformatoren berücksichtigt werden. Die Größe des ersten Signals und die Größe des zweiten Signals sind dann hinreichend gleich, wenn durch die verbleibenden Unterschiede in den Größen die weitere Verarbeitung nicht beeinträchtigt ist.

Viele aus dem Stand der Technik bekannte Detektoren weisen bei Phasenunterschieden zwischen dem ersten Signal und dem zweiten Signal im Bereich von 90° die höchste Genauigkeit auf. Ist ein anderer Phasenunterschied zwischen dem ersten Signal und dem zweiten Signal angestrebt, so kann im Signalpfad einer der beiden Signalkonditionierer ein Phasenschieber zur Verschiebung des Phasenunterschieds zwischen dem ersten Signal und dem zweiten Signal angeordnet sein. Der Phasenschieber kann auch zur Kompensation von Phasenunterschieden eingesetzt werden, die durch unterschiedliche Signallaufzeiten des ersten Signals und des zweiten Signals bedingt sind. Damit ist es möglich, dass der Detektor im Bereich seiner höchsten Genauigkeit arbeitet und ein anderer Phasenunterschied zwischen dem ersten Signal und dem zweiten Signal als 90° vorliegt. Vorzugsweise ist der Phasenschieber in Ausbreitungsrichtungsberichtung des Signals nach dem Dämpfungsglied angeordnet. Durch diese Anordnung muss der Phasenschieber nicht für ungedämpfte Signale ausgebildet sein. Darüber hinaus ermöglicht der erfindungsgemäße Signalanalysator eine Verwendung von Detektoren für die Bestimmung des Phasenunterschieds zwischen zwei Signalen, die für einen Phasenbereich von 0° bis 180° ausgebildet sind.

In einer weiteren bevorzugten Ausgestaltung des erfindungsgemäßen Signalanalysators sind die Leistungssignalleitung, die Wicklung der Primärseite und die Wicklung der Sekundärseite des ersten Transformators und die Wicklung der Primärseite und die Wicklung der Sekundärseite des zweiten Transformators Leiterbahnen. Durch die Implementierung der Leistungssignalleitung und der Transformatoren im Wesentlichen durch Leiterbahnen ist die Anzahl an Bauelementen weiter reduziert. Ein Signalanalysator umfasst für gewöhnlich eine Leiterplatte. Die Leiterbahnen der Leistungssignalleitung und der Wicklungen der Transformatoren können auch auf dieser Leiterplatte angeordnet sein und in demselben Prozess hergestellt sein, in dem auch die übrigen Leiterbahnen auf der Leiterplatte herstellt sind. Das vereinfacht die Herstellung des erfindungsgemäßen Signalanalysators weiter.

Im Einzelnen gibt es nun verschiedene Möglichkeiten, den erfindungsgemäßen Signalanalysator auszugestalten und weiterzubilden. Dazu wird verwiesen auf die dem Patentanspruch 1 nachgeordneten Patentansprüche und auf die Beschreibung eines bevorzugten Ausführungsbeispiels in Verbindung mit der eine Figur umfassenden Zeichnung.

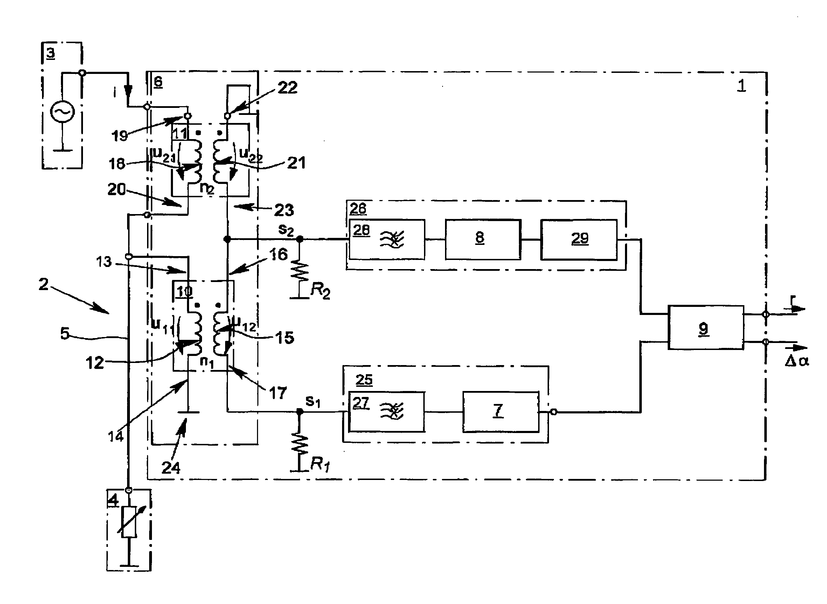

Die Figur zeigt einen erfindungsgemäßen Signalanalysator 1 für kemmagnetische Durchflussmessgeräte. Der Signalanalysator 1 ist in einem Leistungssignalpfad 2 zwischen einem Signalgenerator 3 zur Erzeugung eines elektrischen Anregungssignals und einer elektrischen Last 4 angeordnet. Die Übertragung der elektrischen Anregungssignale erfolgt über eine im Leistungssignalpfad 2 liegenden Leistungssignalleitung 5. Der Signalanalysator 1 umfasst eine Auskoppelschaltung 6 zur Auskopplung eines das in die Last 4 einfallende Anregungssignal charakterisierenden ersten Signals s₁ und zur Auskopplung eines den an der Last 4 reflektierten Teil des Anregungssignals charakterisierenden zweiten Signals s₂. Weiterhin umfasst der Signalanalysator 1 ein erstes Dämpfungsglied 7 und ein zweites Dämpfungsglied 8 sowie einen Detektor 9 zur Bestimmung des Verhältnisses r von der Größe des zweiten Signals s₂ in Relation zur Größe des ersten Signals s₁ und zur Bestimmung des Phasenunterschieds Δα zwischen dem ersten Signal s₁ und dem zweiten Signal s₂.
Die Auskoppelschaltung 6 des erfindungsgemäßen Signalanalysators 1 weist einen ersten Transformator 10 und einen zweiten Transformator 11 auf. Der erste Transformator 10 weist eine Primärseite 12 mit einem Eingang 13 und einem Ausgang 14 und eine Sekundärseite 15 mit einem Eingang 16 und einem Ausgang 17 auf. Der zweite Transformator 11 weist eine Primärseite 18 mit einem Eingang 19 und einem Ausgang 20 und eine Sekundärseite 21 mit einem Eingang 22 und einem Ausgang 23 auf. Die primärseitigen Wicklungen und die sekundärseitigen Wicklungen der beiden Transformatoren 10,11 sind dabei so orientiert und durch den jeweiligen magnetischen Fluss gekoppelt, dass die Spannung U₁₁ an der Primärseite 12 des ersten Transformators 10 in Phase mit der Spannung U₁₂ an der Sekundärseite 15 des ersten Transformators 10 ist und die Spannung U₂₁ an der Primärseite 18 des zweiten Transformators 11 in Phase mit der Spannung U₂₂ an der Sekundärseite 21 des zweiten Transformators 11 ist.

Der primärseitige Eingang 13 des ersten Transformators 10 ist mit der Leistungssignalleitung 5 und der primärseitige Ausgang 14 des ersten Transformators 10 ist mit einem Bezugspotential 24 verbunden. Der primärseitige Eingang 19 und der primärseitige Ausgang 20 des zweiten Transformators 11 sind mit der Leistungssignalleitung 5 verbunden, und der durch die Leistungssignalleitung 5 fließende Strom i fließt vollständig auch durch die Primärseite 18 des zweiten Transformators 11. Der sekundärseitige Eingang 22 des zweiten Transformators 11 ist mit dem Bezugspotential 24 verbunden und der sekundärseitige Ausgang 23 des zweiten Transformators 11 ist mit dem sekundärseitigen Eingang 16 des ersten Transformators 10 verbunden. Am sekundärseitigen Ausgang 17 des ersten Transformators 10 liegt das erste Signal s₁ an, und an der Verbindung von dem sekundärseitigen Eingang 16 des ersten Transformators und dem sekundärseitigen Ausgang 23 des zweiten Transformators liegt das zweite Signal s₂ an.

Der zweite Transformator 11 ist in Ausbreitungsrichtung des Anregungssignals im Leistungssignalpfad 2 vor dem ersten Transformator 10 angeordnet. Demnach ist das erste Signal s₁ ein Maß für die Spannung des in die Last 4 einfallenden Anregungssignals und das Signal s₂ ein Maß für den Strom des von der Last 4 reflektierten Teil des Anregungssignals. Folglich ist der Phasenunterschied zwischen dem ersten Signal s₁ und dem zweiten Signal s₂ bei einem ohmschen Ausgangswiderstand des Signalgenerators 3 und einem ohmschen Eingangswiderstand der Last gerade + 90°.
Das Übersetzungsverhältnis n₂ des zweiten Transformators 11 ist der Kehrwert des Übersetzungsverhältnisses n₁ des ersten Transformators 10. Folglich sind der erste Transformator 10 und der zweite Transformator 11 identisch bis auf vertauschte Primärseiten und Sekundärseiten. Durch die Verwendung von zwei identischen Transformatoren sind Kosten eingespart. Die Anzahl der Windungen der Sekundärseite 15 des ersten Transformators 10 und die Anzahl der Windungen der Primärseite 18 des zweiten Transformators 11 beträgt 1. Die Anzahl der Windungen der Primärseite 12 des ersten Transformators 10 und die Anzahl der Windungen der Sekundärseite 21 des zweiten Transformators 11 beträgt 15. Damit ist das Übersetzungsverhältnis des ersten Transformators 10 n₁ = 15 und das Übersetzungsverhältnis des zweiten Transformators 11 n₂ = 1/15. Durch die Wahl gerade dieser Übersetzungsverhältnisse n₁, n₂ sind die Koppelungen optimal.

Der sekundärseitige Ausgang 17 des ersten Transformators 10 ist über einen ersten Abschlusswiderstand R₁ mit dem Bezugspotential 24 verbunden, und die Verbindung von dem sekundärseitigen Ausgang 23 des zweiten Transformators 11 und dem sekundärseitigen Eingang 16 des ersten Transformators 10 ist über einen zweiten Abschlusswiderstand R₂ mit dem Bezugspotential 24 verbunden. Die beiden Abschlusswiderstände R₁, R₂ haben jeweils den Wert des Leitungswellenwiderstandes der Leistungssignalleitung 5. Durch die Abschlusswiderstände R₁, R₂ werden Reflexionen von sich auf dem Leistungssignalpfad 2 ausbreitenden Signalen vermieden.

Das erste Signal s₁ ist einem ersten Signalkonditionierer 25 und das zweite Signal s₂ ist einem zweiten Signalkonditionierer 26 zugeführt. Der erste Signalkonditionierer 25 umfasst das erste Dämpfungsglied 7 und ein erstes Tiefpassfilter 27. Der zweite Signalkonditionierer 26 umfasst das zweite Dämpfungsglied 8, ein zweites Tiefpassfilter 28 und einen Phasenschieber 29. Das erste Tiefpassfilter 27 und das zweite Tiefpassfilter 28 dienen zur Dämpfung von unerwünschten Frequenzanteilen in den beiden Signalen s₁, s₂. Im Signalpfad des ersten Signalkonditionierers 25 folgt in Signalflussrichtung auf das erste Tiefpassfilter 27 das erste Dämpfungsglied 7. Im Signalpfad des zweiten Signalkonditionerers 26 folgt in Signalflussrichtung auf das zweite Tiefpassfilter 28 das zweite Dämpfungsglied 8 und auf das Dämpfungsglied 8 folgt der Phasenschieber 29.

Das von der ersten Signalkonditionierung 25 konditionierte erste Signal s₁ und das von der zweiten Signalkonditionierung 26 konditionierte zweite Signal s₂ sind dem Detektor 9 zugeführt. Der Detektor 9 bestimmt das Verhältnis der Größe des konditionierten ersten Signals s₁ zur Größe des konditionierten zweiten Signals s₂ und bestimmt den Phasenunterschied zwischen dem konditionierten ersten Signal s₁ und dem konditionierten Signal s₂.

### Bezugszeichen:

- 1.: Signalanalysator
- 2.: Leistungssignalpfad
- 3.: Signalgenerator
- 4.: elektrische Last
- 5.: Leistungssignalleitung
- 6.: Auskoppelschaltung
- 7.: erstes Dämpfungsglied
- 8.: zweites Dämpfungsglied
- 9.: Detektor
- 10.: erster Transformator
- 11.: zweiter Transformator
- 12.: Primärseite des ersten Transformators
- 13.: Eingang der Primärseite des ersten Transformators
- 14.: Ausgang der Primärseite des ersten Transformators
- 15.: Sekundärseite des ersten Transformators
- 16.: Eingang der Sekundärseite des ersten Transformators
- 17.: Ausgang der Sekundärseite des ersten Transformators
- 18.: Primärseite des zweiten Transformators
- 19.: Eingang der Primärseite des zweiten Transformators
- 20.: Ausgang der Primärseite des zweiten Transformators
- 21.: Sekundärseite des zweiten Transformators
- 22.: Eingang der Sekundärseite des zweiten Transformators
- 23.: Ausgang der Sekundärseite des zweiten Transformators
- 24.: Bezugspotential
- 25.: erster Signalkonditionierer
- 26.: zweiter Signalkonditionierer
- 27.: erstes Tiefpassfilter
- 28.: zweites Tiefpassfilter
- 29.: Phasenschieber
- *s*₁: erstes Signal
- s₂: zweites Signal
- r: Verhältnis von der Größe von s₁ und der Größe von s₂
- Δα: Phasenunterschied zwischen s₁ und s₂
- *u*₁₁: Spannung über die Primärseite des ersten Transformators
- *u*₁₂: Spannung über die Sekundärseite des ersten Transformators
- *u*₂₁: Spannung über die Primärseite des zweiten Transformators
- *u*₂₂: Spannung über die Sekundärseite des zweiten Transformators
- *i*: Strom des Signalgenerators
- *n*₁: Übersetzungsverhältnis des ersten Transformators
- *n*₂: Übersetzungsverhältnis des zweiten Transformators
- *R*₁: erster Abschlusswiderstand
- *R*₂: zweiter Abschlusswiderstand

## Patentansprüche

1. Signalanalysator (1), insbesondere für kernmagnetische Durchflussmessgeräte, zur Anordnung in einem Leistungssignalpfad (2) zwischen einem Signalgenerator (3) zur Erzeugung eines elektrischen Anregungssignals und einer elektrischen Last (4),
mit einer, bei Anordnung des Signalanalysators (1) im Leistungssignalpfad (2), im Leistungssignalpfad (2) liegenden Leistungssignalleitung (5) zur Übertragung von elektrischen Signalen,
mit einer Auskoppelschaltung (6) zur Auskopplung eines das in die Last (4) einfallende Anregungssignal charakterisierenden ersten Signals und zur Auskopplung eines den an der Last (4) reflektierten Teil des Anregungssignals charakterisierenden zweiten Signals und
mit einem Detektor (9) zur Bestimmung des Verhältnisses der Größe des ersten Signals zur Größe des zweiten Signals und zur Bestimmung des Phasenunterschieds zwischen dem ersten Signal und dem zweiten Signal,
**dadurch gekennzeichnet,**
**dass** die Auskoppelschaltung (6) einen ersten Transformator (10) und einen zweiten Transformator (11) aufweist,
**dass** der erste Transformator (10) eine Primärseite (12) mit einem Eingang (13) und einem Ausgang (14) und eine Sekundärseite (15) mit einem Eingang (16) und einem Ausgang (17) aufweist und der zweite Transformator (11) eine Primärseite (18) mit einem Eingang (19) und einem Ausgang (20) und eine Sekundärseite (21) mit einem Eingang (22) und einem Ausgang (23) aufweist,
**dass** die Spannung am primärseitigen Eingang (13, 19) in Bezug auf den primärseitigen Ausgang (14, 20) jedes Transformators (10, 11) in Phase mit der Spannung an dessen sekundärseitigem Eingang (16, 22) in Bezug auf dessen sekundärseitigem Ausgang (17, 23) ist,
**dass** der primärseitige Eingang (13) des ersten Transformators (10) mit der Leistungssignalleitung (5) und der primärseitige Ausgang (14) des ersten Transformators (10) mit einem Bezugspotential (24) verbunden ist, der primärseitige Eingang (19) und der primärseitige Ausgang (20) des zweiten Transformators (11) mit der Leistungssignalleitung (5) verbunden sind und der durch die Leistungssignalleitung (5) fließende Strom durch die Primärseite (18) des zweiten Transformators (11) fließt,
**dass** der sekundärseitige Eingang (22) des zweiten Transformators (11) mit dem Bezugspotential (24) und der sekundärseitige Ausgang (23) des zweiten Transformators (11) mit dem sekundärseitigen Eingang (16) des ersten Transformators (10) verbunden ist und
**dass** am sekundärseitigen Ausgang (17) des ersten Transformators (10) das erste Signal anliegt und an der Verbindung von dem sekundärseitigen Eingang (16) des ersten Transformators (10) und dem sekundärseitigen Ausgang (23) des zweiten Transformators (11) das zweite Signal anliegt.

2. Signalanalysator nach Anspruch 1, **dadurch gekennzeichnet, dass** der zweite Transformator (11) in Ausbreitungsrichtung des Anregungssignals im Leistungssignalpfad (2) vor dem ersten Transformator (10) angeordnet ist.

3. Signalanalysator nach Anspruch 1 oder 2, **dadurch gekennzeichnet, dass** das Übersetzungsverhältnis n₂ des zweiten Transformators (11) der Kehrwert des Übersetzungsverhältnisses n₁ des ersten Transformators (10) ist.

4. Signalanalysator nach einem der Ansprüche 1 bis 3, **dadurch gekennzeichnet, dass** der sekundärseitige Ausgang (17) des ersten Transformators (10) über einen ersten Abschlusswiderstand R₁ mit dem Bezugspotential (24) verbunden ist und die Verbindung von dem sekundärseitigen Ausgang (23) des zweiten Transformators (11) und dem sekundärseitigen Eingang (16) des ersten Transformators (10) über einen zweiten Abschlusswiderstand R₂ mit dem Bezugspotential (24) verbunden ist.

5. Signalanalysator nach Anspruch 4, **dadurch gekennzeichnet, dass** die beiden Abschlusswiderstände R₁, R₂ jeweils den Wert des Leitungswellenwiderstands der Leistungssignalleitung (5) aufweisen.

6. Signalanalysator nach einem der Ansprüche 1 bis 5, **dadurch gekennzeichnet, dass** das erste Signal einem ersten Signalkonditionierer (25) und das zweite Signal einem zweiten Signalkonditionierer (26) zugeführt ist, im Signalpfad des ersten Signalkonditionierers (25) ein erstes Dämpfungsglied (7) und ein erstes Tiefpassfilter (27) angeordnet sind, im Signalpfad der zweiten Signalkonditionierers (26) ein zweites Dämpfungsglied (8) und ein zweites Tiefpassfilter (28) angeordnet sind und die beiden Tiefpassfilter (27, 28) zur Dämpfung von unerwünschten Frequenzanteilen in den beiden Signalen ausgelegt sind.

7. Signalanalysator nach Anspruch 6, **dadurch gekennzeichnet, dass** in dem Signalpfad jeder der beiden Signalkonditionierer (25, 26) das Tiefpassfilter (27, 28) in Ausbreitungsrichtung des Signals vor dem Dämpfungsglied (7, 8) angeordnet ist.

8. Signalanalysator nach Anspruch 6 oder 7, **dadurch gekennzeichnet, dass** die Dämpfung des ersten Dämpfungsglieds (7) und die Dämpfung des zweiten Dämpfungsglieds (8), insbesondere unter Berücksichtigung der Übersetzungsverhältnisse n₁, n₂ der beiden Transformatoren (10, 11), derart aufeinander abgestimmt sind, dass das erste Signal am Ausgang des ersten Dämpfungsglieds (7) und das zweite Signal am Ausgang des zweiten Dämpfungsglieds (8) für die Weiterverarbeitung hinreichend gleiche Größen aufweisen.

9. Signalanalysator nach einem der Ansprüche 6 bis 8, **dadurch gekennzeichnet, dass** im Signalpfad einer der beiden Signalkonditionierer (25, 26) ein Phasenschieber (29) zur Veränderung des Phasenunterschieds zwischen dem ersten Signal und dem zweiten Signal angeordnet ist.

10. Signalanalysator nach Anspruch 9, **dadurch gekennzeichnet, dass** der Phasenschieber (29) im Signalpfad des entsprechenden Signalkonditionierers (25,26) in Ausbreitungsrichtung des Signals nach dem Dämpfungsglied (7, 8) angeordnet ist.

11. Signalanalysator nach einem der Ansprüche 1 bis 10, **dadurch gekennzeichnet, dass** der Detektor (9) für die Bestimmung von Phasenunterschieden von zwei Signalen im Phasenbereich von 0° bis 180° ausgebildet ist.

12. Signalanalysator nach einem der Ansprüche 1 bis 11, **dadurch gekennzeichnet, dass** die Leistungssignalleitung, die Wicklung der Primärseite und die Wicklung der Sekundärseite des ersten Transformators und die Wicklung der Primärseite und die Wicklung der Sekundärseite des zweiten Transformators Leiterbahnen sind.

## Claims

1. Signal analyzer (1), particularly for nuclear magnetic flowmeters, for placement in a power signal path (2) between a signal generator (3) for generating an electric excitation signal and an electrical load (4) having, when the signal analyzer (1) is placed in the power signal path (2), a power signal line (5) in the power signal path (2) for the transmission of electrical signals,
having an extraction circuit (6) for extracting a first signal characterizing the excitation signal incident into the load (4) and for extracting a second signal characterizing the part of the excitation signal reflected at the load (4) and having a detector (9) for determining the ratio of the magnitude of the first signal to the magnitude of the second signal and for determining the phase difference between the first signal and the second signal,
**characterized in**
**that** the extraction circuit (6) has a first transformer (10) and a second transformer (11),
**that** the first transformer (10) has a primary side (12) with an input (13) and an output (14) and has a secondary side (15) with an input (16) and an output (17) and the second transformer (11) has a primary side (18) with an input (19) and an output (20) and has a secondary side (21) with an input (22) and an output (23),
**that** the voltage on the primary-side input (13, 19) with respect to the primary-side output (14, 20) of each transformer (10, 11) is in phase with the voltage at its secondary-side input (16, 22) with respect to its secondary-side output (17, 23),
**that** the primary-side input (13) of the first transformer (10) is connected to the power signal line (5) and the primary-side output (14) of the first transformer (10) is connected to a reference potential (24), the primary-side input (19) and the primary-side output (20) of the second transformer (11) are connected to the power signal line (5) and the current flowing through the power signal line (5) flows through the primary side (18) of the second transformer (11),
**that** the secondary-side input (22) of the second transformer (11) is connected to the reference potential (24) and the secondary-side output (23) of the second transformer (11) is connected to the secondary-side input (16) of the first transformer (10) and
**that** the first signal is output at the secondary-side output (17) of the first transformer (10) and the second signal is output at the connection of the secondary-side input (16) of the first transformer (10) and the secondary-side output (23) of the second transformer (11).

2. Signal analyzer according to claim 1, **characterized in that** the second transformer (11) is arranged in the direction of propagation of the excitation signal on the power signal path (2) before the first transformer (10).

3. Signal analyzer according to claim 1 or 2, **characterized in that** the transformation ratio n₂ of the second transformer (11) is the reciprocal of the transformation ratio n₁ of the first transformer (10).

4. Signal analyzer according to any one of claims 1 to 3, **characterized in that** the secondary-side output (17) of the first transformer (10) is connected to the reference potential (24) via a first terminating resistor R₁ and the connection from the secondary-side output (23) of the second transformer (11) and the secondary-side input (16) of the first transformer (10) is connected to the reference potential (24) via a second terminating resistor R₂.

5. Signal analyzer according to claim 4, **characterized in that** both terminating resistors R₁, R₂ each exhibit the value of the characteristic impedance of the power signal line (5).

6. Signal analyzer according to any one of claims 1 to 5, **characterized in that** the first signal is supplied to a first signal conditioner (25) and the second signal to a second signal conditioner (26), a first attenuator (7) and a first low-pass filter (27) being arranged in the signal path of the first signal conditioner (25), a second attenuator (8) and a second low-pass filter (28) being arranged in the signal path of the second signal conditioner (26) and both low-pass filters (27, 28) being designed for damping of unwanted frequency components in the two signals.

7. Signal analyzer according to claim 6, **characterized in that** the low-pass filter (27, 28) is arranged in the signal path of both signal conditioners (25, 26) in the direction of propagation of the signal before the attenuator (7, 8).

8. Signal analyzer according to claim 6 or 7, **characterized in that** the damping of the first attenuator (7) and the damping of the second attenuator (8), in particular taking account of the transformation ratio n₁, n₂ of the two transformers (10, 11), are attuned to one another so that the first signal at the output of the first attenuator (7) and the second signal at the output of the second attenuator (8) are sufficiently equal for further processing.

9. Signal analyzer according to any one of claims 6 to 8, **characterized in that** a phase shifter (29) is arranged in the signal path of one of the two signal conditioners (25, 26) for varying the phase difference between the first signal and the second signal.

10. Signal analyzer according to claim 9, **characterized in that** the phase shifter (29) is arranged in the signal path of the corresponding signal conditioner (25, 26) in the direction of propagation of the signal after the attenuator (7, 8).

11. Signal analyzer according to any one of claims 1 to 10, **characterized in that** the detector (9) is designed for determining phase differences of two signals in the phase range from 0° to 180°.

12. Signal analyzer according to any one of 1 to 11, **characterized in that** the power signal line, the coil of the primary side and the coil of the secondary side of the first transformer, and the coil of the primary side and the coil of the secondary side of the second transformer are printed circuit board traces.

## Revendications

1. Analyseur de signal (1), notamment pour des débitmètres magnétiques nucléaires, destiné à être disposé dans un trajet de signal de puissance (2) entre un générateur de signal (3) destiné à générer un signal d'excitation électrique et une charge électrique (4), comprenant, lors de la disposition de l'analyseur de signal (1) dans le trajet de signal de puissance (2), une ligne de signal de puissance (5) qui se trouve dans le trajet de signal de puissance (2) pour la transmission de signaux électriques,
comprenant un circuit de découplage (6) destiné à découpler un premier signal caractérisant le signal d'excitation incident dans la charge (4) et destiné à découpler un deuxième signal caractérisant la partie du signal d'excitation réfléchie au niveau de la charge (4) et
comprenant un détecteur (9) destiné à déterminer le rapport entre l'amplitude du premier signal et l'amplitude du deuxième signal et destiné à déterminer la différence de phase entre le premier signal et le deuxième signal,
**caractérisé en ce**
**que** le circuit de découplage (6) possède un premier transformateur (10) et un deuxième transformateur (11), en ce que le premier transformateur (10) possède un côté primaire (12) muni d'une entrée (13) et d'une sortie (14) et un côté secondaire (15) muni d'une entrée (16) et d'une sortie (17) et le deuxième transformateur (11) possède un côté primaire (18) muni d'une entrée (19) et d'une sortie (20) et un côté secondaire (21) muni d'une entrée (22) et d'une sortie (23),
en ce que la tension à l'entrée côté primaire (13, 19), en référence à la sortie côté primaire (14, 20) de chaque transformateur (10, 11), est en phase avec la tension à son entrée côté secondaire (16, 22) en référence à sa sortie côté secondaire (17, 23),
en ce que l'entrée côté primaire (13) du premier transformateur (10) est reliée à la ligne de signal de puissance (5) et la sortie côté primaire (14) du premier transformateur (10) est reliée à un potentiel de référence (24), l'entrée côté primaire (19) et la sortie côté primaire (20) du deuxième transformateur (11) sont reliées à la ligne de signal de puissance (5) et le courant qui circule à travers la ligne de signal de puissance (5) circule à travers le côté primaire (18) du deuxième transformateur (11),
en ce que l'entrée côté secondaire (22) du deuxième transformateur (11) est reliée au potentiel de référence (24) et la sortie côté secondaire (23) du deuxième transformateur (11) est reliée à l'entrée côté secondaire (16) du premier transformateur (10) et
en ce que le premier signal est présent à la sortie côté secondaire (17) du premier transformateur (10) et le deuxième signal est présent à la liaison de l'entrée côté secondaire (16) du premier transformateur (10) et de la sortie côté secondaire (23) du deuxième transformateur (11).

2. Analyseur de signal selon la revendication 1, **caractérisé en ce que** le deuxième transformateur (11) est disposé avant le premier transformateur (10) dans le trajet de signal de puissance (2) dans le sens de propagation du signal d'excitation.

3. Analyseur de signal selon la revendication 1 ou 2, **caractérisé en ce que** le rapport de transformation n₂ du deuxième transformateur (11) est la valeur inverse du rapport de transformation n₁ du premier transformateur (10).

4. Analyseur de signal selon l'une des revendications 1 à 3, **caractérisé en ce que** la sortie côté secondaire (17) du premier transformateur (10) est reliée au potentiel de référence (24) par le biais d'une première résistance de terminaison R₁ et la liaison de la sortie côté secondaire (23) du deuxième transformateur (11) et de l'entrée côté secondaire (16) du premier transformateur (10) est reliée au potentiel de référence (24) par le biais d'une deuxième résistance de terminaison R₂.

5. Analyseur de signal selon la revendication 4, **caractérisé en ce que** les deux résistances de terminaison R₁, R₂ possèdent respectivement la valeur de l'impédance de ligne de la ligne de signal de puissance (5) .

6. Analyseur de signal selon l'une des revendications 1 à 5, **caractérisé en ce que** le premier signal est acheminé à un premier conditionneur de signal (25) et le deuxième signal à un deuxième conditionneur de signal (26), un premier atténuateur (7) et un premier filtre passe-bas (27) sont disposés dans le trajet de signal du premier conditionneur de signal (25), un deuxième atténuateur (8) et un deuxième filtre passe-bas (28) sont disposés dans le trajet de signal du deuxième conditionneur de signal (26) et les deux filtres passe-bas (27, 28) sont conçus pour atténuer les composantes de fréquence indésirables dans les deux signaux.

7. Analyseur de signal selon la revendication 6, **caractérisé en ce que** dans le trajet de signal des deux conditionneurs de signal (25, 26), le filtre passe-bas (27, 28) est disposé avant l'atténuateur (7, 8) dans le sens de propagation du signal.

8. Analyseur de signal selon la revendication 6 ou 7, **caractérisé en ce que** l'atténuation du premier atténuateur (7) et l'atténuation du deuxième atténuateur (8), notamment en tenant compte des rapports de transformation n₁, n₂ des deux transformateurs (10, 11), sont accordées l'une sur l'autre de telle sorte que le premier signal à la sortie du premier atténuateur (7) et le deuxième signal à la sortie du deuxième atténuateur (8) possèdent les mêmes amplitudes suffisantes pour le traitement postérieur.

9. Analyseur de signal selon l'une des revendications 6 à 8, **caractérisé en ce qu'**un déphaseur (29) destiné à modifier la différence de phase entre le premier signal et le deuxième signal st disposé dans le trajet de signal de l'un des deux conditionneurs de signal (25, 26).

10. Analyseur de signal selon la revendication 9, **caractérisé en ce que** le déphaseur (29) dans le trajet de signal du conditionneur de signal (25, 26) correspondant est disposé après l'atténuateur (7, 8) dans le sens de propagation du signal.

11. Analyseur de signal selon l'une des revendications 1 à 10, **caractérisé en ce que** le détecteur (9) est conçu pour déterminer les différences de phase de deux signaux dans la plage de phases de 0° à 180°.

12. Analyseur de signal selon l'une des revendications 1 à 11, **caractérisé en ce que** la ligne de signal de puissance, l'enroulement du côté primaire et l'enroulement du côté secondaire du premier transformateur ainsi que l'enroulement du côté primaire et l'enroulement du côté secondaire du deuxième transformateur sont des pistes conductrices.
